# EUROPÄISCHE PATENTANMELDUNG

(11) **EP 2 690 630 A1**
(43) Veröffentlichungstag der Anmeldung: **29.01.2014**
(21) Anmeldenummer: 12177745.2
(22) Anmeldetag: 25.07.2012
(51) Int. Cl.: G11C 16/34

(54) **Halbleiterbaustein und Verfahren zum Betrieb**

(71) Anmelder: Siemens Aktiengesellschaft, 80333 München (DE)
(72) Erfinder: Renn, Harald, 90408 Nürnberg (DE)

(57) **Zusammenfassung**

Die Erfindung betrifft einen Halbleiterspeicherbaustein (1) mit einer Vielzahl von Speicherzellen (101,...,108), wobei je eine Speicherzelle (101,...,108) zum Abspeichern einer Information (10) ausgestaltet ist und die Information (10) in Form einer elektrischen Ladung vorliegt, wobei eine Referenzspeicherzelle (R1,...,R8), welche gegenüber den anderen Speicherzellen (101,...,108) derart verändert ausgestaltet ist, dass ihre Retention gegenüber der Retention der anderen Speicherzellen (101,...,108) geringer ist.

## Beschreibung

Die Erfindung betrifft einen Halbleiterbaustein mit einer Vielzahl von Speicherzellen, wobei je eine Speicherzelle zum Abspeichern einer Information ausgestaltet ist und die Information in Form einer elektrischen Ladung vorliegt.

Des Weiteren betrifft die Erfindung ein Verfahren zum Betrieb eines Halbleiterbausteins mit einer Vielzahl von Speicherzellen, wobei je eine Speicherzelle zum Abspeichern einer Information genutzt wird und die Information in Form einer elektrischen Ladung abgespeichert wird.

Da Speicherzellen innerhalb eines Halbleiterspeicherbausteins einer Retention unterliegen, müssen die einzelnen Speicherzellen in einem NOR- oder NAND-Flash immer wieder aufgefrischt werden. Vorzugsweise wird dazu ein Speicherbereich periodisch in einen anderen Bereich kopiert und der vorherige Bereich gelöscht, um wieder mit frisch geladenen Speicherzellen fortzufahren. Im Sinne der Erfindung und in Bezug auf Speicherzellen wird unter Retention eine Zeitspanne verstanden, in der Daten lesbar bleiben. Da Elektronen einer elektrischen Ladung beispielsweise von einem Floating-Gate einer Speicherzelle spontan abwandern können, verliert diese Speicherzelle im Laufe der Zeit ihre Ladung. Da die Information in Form einer elektrischen Ladung vorliegt, kann nach einer gewissen Zeit die abgespeicherte Information nicht mehr sicher zurückgelesen werden.

Aus der Patentschrift DE 100 57 275 C1 ist eine Schaltung und ein Verfahren zum Auffrischen von Speicherzellen bekannt. In dem aufgezeigten Speicher werden die Speicherzellen so aufgefrischt, dass die zeitliche Abfolge von Steuersignalen zum Auslösen eines Informationsauffrischungsvorganges für die einzelnen Speicherzellen entsprechend der jeweiligen maximalen Speicherzeit für die Informationen in der Speicherzelle eingestellt wird. Hierzu ist ein zyklisches Auffrischen über einen Zeitgeber notwendig.

Demnach gibt es nach dem Stand der Technik verschiedene Möglichkeiten, den Zeitpunkt eines notwendigen Auffrischungsvorganges zu bestimmen. Es kann ein fester Zeitpunkt, z.B. jeweils nach zwei Jahren, festgelegt werden, bei dem eine Auffrischung bzw. eine Neuprogrammierung eines Halbleiterspeicherbausteins stattfinden soll. Ist ein Uhrenbaustein oder eine Verbindung zu einer Synchronisationszeit, beispielsweise Ethernet, Profibus, vorhanden, kann der Zeitpunkt zum Auffrischen des Halbleiterbausteins aus einer Zeitmessung des entsprechenden Kommunikationsbusses bestimmt werden. Oder es wird aus einer von einem Betriebsstundenzähler gemessenen Gesamteinschaltdauer der Zeitpunkt für einen Auffrischungsvorgang festgelegt.

Es ist Aufgabe der Erfindung auf einen externen Zeitgeber, welcher den Zeitpunkt für einen Auffrischungsvorgang ermittelt, zu verzichten.

Die Aufgabe wird durch einen Halbleiterspeicherbaustein mit einer Vielzahl von Speicherzellen gelöst, wobei je eine Speicherzelle zum Abspeichern einer Information ausgestaltet ist und die Information in Form einer elektrischen Ladung vorliegt, wobei eine Referenzspeicherzelle vorhanden ist, welche gegenüber den anderen Speicherzellen derart verändert ausgestaltet ist, dass ihre Retention gegenüber der Retention der anderen Speicherzellen geringer ist. Durch eine Implementierung einer zusätzlichen Speicherzelle, nämlich einer Referenzspeicherzelle, die vorzugsweise eine höhere Ausfallrate als die in dem Halbleiterspeicherbaustein bereits verwendeten Speicherzellen hat, kann bestimmt werden, ab welchem Zeitpunkt ein Auffrischungsvorgang gestartet werden muss, weil diese Referenzspeicherzelle ihren Inhalt früher verliert. Dazu wird vorteilhafter Weise an die Referenzspeicherzelle eine Überwachungseinheit angeschaltet, welche gezielt prüft, ob die Information in der Referenzspeicherzelle noch lesbar ist. Da die Referenzspeicherzelle derart ausgestaltet ist, dass sie ihre elektrische Ladung mit Sicherheit schneller verliert als die übrigen Speicherzellen kann somit mit Sicherheit rechtzeitig ein Auffrischungsvorgang gestartet werden.

Vorzugsweise sind die Speicherzellen und die Referenzspeicherzelle jeweils als ein Floating-Gate-Transistor aufgebaut.

In einer Ausgestaltungsvariante mit einem Floating-Gate-Transistor weist die Speicherzelle einen Source-Anschluss, einen Drain-Anschluss und einen Control-Gate-Anschluss auf, wobei ein Floating-Gate zwischen dem Source-Anschluss und den Drain-Anschluss unterhalb des Control-Gate-Anschlusses innerhalb einer Oxidschicht angeordnet ist.

Dabei ist die Referenzspeicherzelle ausgestaltet um aus dem von einem ersten Zeitpunkt des Beschreibens mit Informationen der Referenzspeicherzelle und der anderen Speicherzellen schneller ihre Ladung bis zu einem zweiten Zeitpunkt zu verlieren, als die Speicherzelle ihre elektrische Ladung bis zu diesen zweiten Zeitpunkt verlieren würde.

Um die Ausgestaltung der Referenzspeicherzelle im Hinblick auf ihre Retention oder Datenerhaltezeit zu verändern, wird vorzugsweise eine Größe des Floating-Gates der Referenzspeicherzelle derart verändert, dass eine Größe des Floating-Gates der Referenzspeicherzelle kleiner ist als eine Größe eines Floating-Gates einer der übrigen Speicherzellen. Beispielsweise könnte die Breite eines Floating-Gates einer Referenzspeicherzelle kleiner ausgelegt sein als eine Breite der Floating-Gates der übrigen Speicherzellen auf dem Halbleiterspeicherbaustein.

Um möglichst eine Vielzahl von beeinflussenden Parametern zu erfassen, sind die Referenzspeicherzellen vorzugsweise derart zwischen oder in der Nähe der anderen Speicherzellen angeordnet, und zwar derart, dass auf die Referenzspeicherzelle im Wesentlichen die gleichen Einflüsse wirken, wie auf die anderen Speicherzellen.

Vorteilhafter Weise umfassen die Einflüsse, eine Umgebungstemperatur, eine herstellerspezifische Fertigungstechnologie, eine Größe der Versorgungsspannung, eine Anzahl von Schreibvorgängen. Nach dem Stand der Technik wurde aus den zuvor genannten Einflüssen oder Parametern rechnerisch eine Zeit gebildet, ab der ein Auffrischungsvorgang stattfinden soll. Diese Zeitberechnung war ungenau und konnte u.U. falsch errechnet sein, so dass vorzeitig Speicherzellen ihre Information verloren hatten bevor die Speicherzellen durch einen Auffrischungsvorgang regeneriert wurden. Um diese Ungenauigkeit zu beseitigen, werden unter Berücksichtigung der Einflüsse auf den Halbleiterspeicherbaustein die Referenzspeicherzellen vorzugsweise neben den normalen Speicherzellen bei der Herstellung eingearbeitet. Dabei ist beispielsweise ein Floating-Gate einer Referenzspeicherzelle derart modifiziert, dass diese Referenzspeicherzelle durch das modifizierte Floating-Gate bereits nach ca. 80 Prozent der "Lebensdauer" einer der übrigen Speicherzellen ausfällt, und ab diesen Zeitpunkt kann mit Sicherheit ein Auffrischungsvorgang gestartet werden. Somit ist sichergestellt, dass alle relevanten Einflüsse mit berücksichtigt wurden, da sich die Referenzspeicherzelle auf der gleichen baulichen Einheit wie die übrigen Speicherzellen des Halbleiterspeicherbausteins befindet.

In einer besonderen Weiterbildung des Halbleiterbausteins weist dieser weitere Referenzspeicherzellen auf, wobei diese weiteren Referenzspeicherzellen kaskadiert sind und dabei in dieser Kaskade die Größe des Floating-Gates von einer Referenzspeicherzelle zur nächsten Referenzspeicherzelle zunimmt. Durch eine derartige Kaskadierung der Referenzspeicherzellen, beispielsweise in einem Referenzregister, kann eine Prognose auf eine mögliche Ausfallzeit von Speicherzellen noch besser gegeben werden. So würde beispielsweise die Information der ersten Referenzspeicherzelle schneller verloren gehen als die Information der weiter hinter der ersten Referenzspeicherzelle liegenden Referenzspeicherzellen der Kaskade. Es könnte beispielsweise eine prozentuale Aussage getroffen werden, wie viel Restzeit für eine sichere Informationserhaltung noch zur Verfügung steht.

Die eingangs genannte Aufgabe wird auch durch ein Verfahren zum Betrieb eines Halbleiterspeicherbausteins mit einer Vielzahl von Speicherzellen, wobei je eine Speicherzelle zum Abspeichern einer Information genutzt wird und die Information in Form einer elektrischen Ladung abgespeichert wird, dadurch gelöst, dass eine zyklische Abfrage einer Referenzspeicherzelle erfolgt, wobei die Referenzspeicherzelle gegenüber den anderen Speicherzellen derart verändert ausgestaltet ist, dass ihre Retention gegenüber der Retention der anderen Speicherzellen geringer ist, wobei die Referenzspeicherzelle ausgehend von einem ersten Zeitpunkt des Beschreibens mit einer Information der Referenzspeicherzelle und der anderen Speicherzellen schneller ihre elektrische Ladung bis zu einem zweiten Zeitpunkt verliert, als die Speicherzelle ihre elektrische Ladung bis zu diesen zweiten Zeitpunkt verlieren würde, ergibt die Abfrage der Referenzspeicherzelle, dass die zuvor eingeschriebene Information nicht mehr zurücklesbar ist, so wird ein Auffrischungsvorgang der anderen Speicherzellen gestartet.

Um eine Prognose zu geben, wie viel Zeit einer Datenerhaltenzeit, nämlich der Retention noch vorhanden ist, werden weitere Referenzspeicherzellen abgefragt, wobei diese weiteren Referenzspeicherzellen kaskadiert sind und dabei in dieser Kaskade die Größe des Floating-Gates von einer Referenzspeicherzelle zur nächsten Referenzspeicherzelle zunimmt, wodurch eine Aussage über einen bereits erfolgten Abfluss von elektrischer Ladung aus den Speicherzellen getroffen werden kann.

Die Zeichnung zeigt ein Ausführungsbeispiel. Es zeigt die
- FIG 1: schematisch einen Halbleiterspeicherbaustein mit Speicherzellen,
- FIG 2: eine Prinzipdarstellung einer Speicherzelle in der Aufbauart eines Floating-Gate-Transistors und
- FIG 3: einen Ausschnitt eines Halbleiterspeicherbausteins mit Sicht auf eine Kaskade von Referenzspeicherzellen.

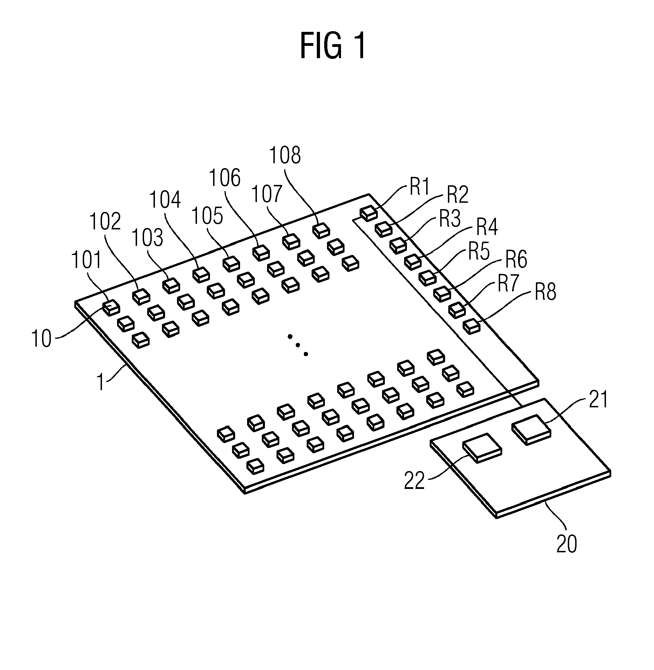

Gemäß FIG 1 ist ein Halbleiterspeicherbaustein 1 mit einer Vielzahl von Speicherzellen 101,...,108 zum Abspeichern von Informationen 10 dargestellt. Die Informationen 10 liegen in Form einer elektrischen Ladung in den einzelnen Speicherzellen 101,...,108 vor. Der Halbleiterspeicherbaustein 1 weist eine Referenzspeicherzelle R1 auf, welche gegenüber den anderen Speicherzellen 101,...,108 derart verändert ausgestaltet ist, dass ihre Retention gegenüber der Retention der anderen Speicherzellen 101,...,108 geringer ist. An die Referenzspeicherzelle R1 ist ein Auslesemittel 20, welches ausgestaltet ist als eine Überwachungseinheit, angeschlossen. Dieses Auslesemittel 20 liest zyklisch den Informationswert der Referenzspeicherzelle R1 aus. Über ein Bewertungsmittel 21 wird geprüft, ob der ausgelesene Wert der Information noch dem Wert entspricht, der zuvor ausgelesen wurde. Sollte dies nicht der Fall sein, so wird über ein Auffrischungsmittel 22 der Halbleiterspeicherbaustein 1 derart angesteuert, dass alle Speicherzellen 101,...,108 und alle Referenzspeicherzellen aufgefrischt werden.

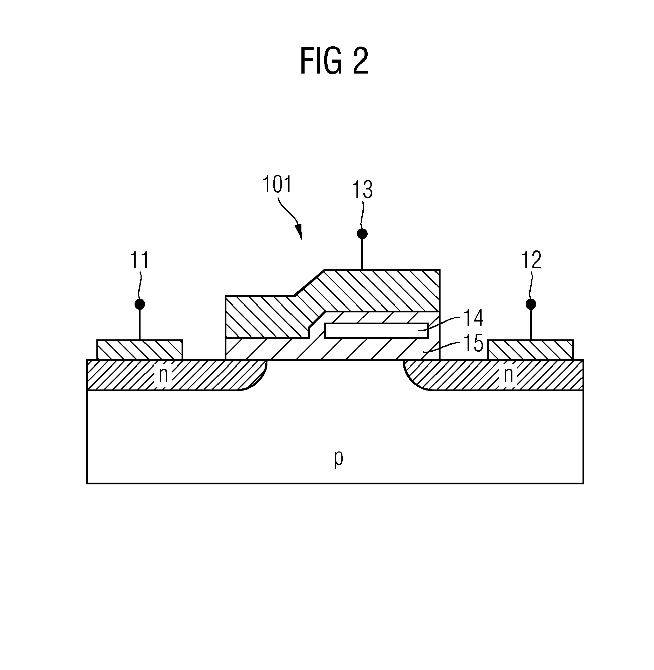

In der FIG 1 ist exemplarisch nur ein Anschluss von dem Auslesemittel 20 zu einer ersten Referenzspeicherzelle R1 gezeigt. Um eine prozentuale Aussage des Verlustes einer Retention, oder einer Datenerhaltezeit einer einzelnen Speicherzelle 101,...,108 zu geben, sind in einer Kaskade die erste Referenzpeicherzelle R1, eine zweite Referenzspeicherzelle R2, eine dritte Referenzspeicherzelle R3, eine vierte Referenzspeicherzelle R4, eine fünfte Referenzspeicherzelle R5, eine sechste Referenzspeicherzelle R6, eine siebte Referenzspeicherzelle R7 und eine achte Referenzspeicherzelle R8 angeordnet. In dieser Kaskade nimmt eine Größe des Floating-Gates 14 (siehe FIG 2) von der ersten Referenzspeicherzelle R1 über die zweite Referenzspeicherzelle R2 bis hin zur achten Referenzspeicherzelle R8 kontinuierlich zu. Die Größe des Floating-Gates in der achten Referenzspeicherzelle R8 überschreitet jedoch nicht die Größe eines Floating-Gates 14 einer "normalen" Speicherzelle 101.

Gemäß FIG 2 ist schematisch eine Speicherzelle 101 in der Aufbauform eines Floating-Gate-Transistors dargestellt. Die Speicherzelle 101 weist einen Source-Anschluss 11, einen Drain-Anschluss 12 und einen Control-Gate-Anschluss 13 auf. Innerhalb einer Oxidschicht 15 ist ein Floating-Gate 14 zwischen dem Source-Anschluss 11 und dem Drain-Anschluss 12 unterhalb eines Control-Gate-Anschlusses 13 angeordnet. Ein Substrat an dem das Control-Gate 13, das Floating.Gate 14 und die Oxidschicht 15 angeordnet ist, kann als ein P-Kanal p angesehen werden. In diesem P-Kanal p bildet sich von dem Source-Anschluss 11 ein N-Kanal n aus und von dem Drain-Anschluss 12 ein weiterer N-Kanal n aus.

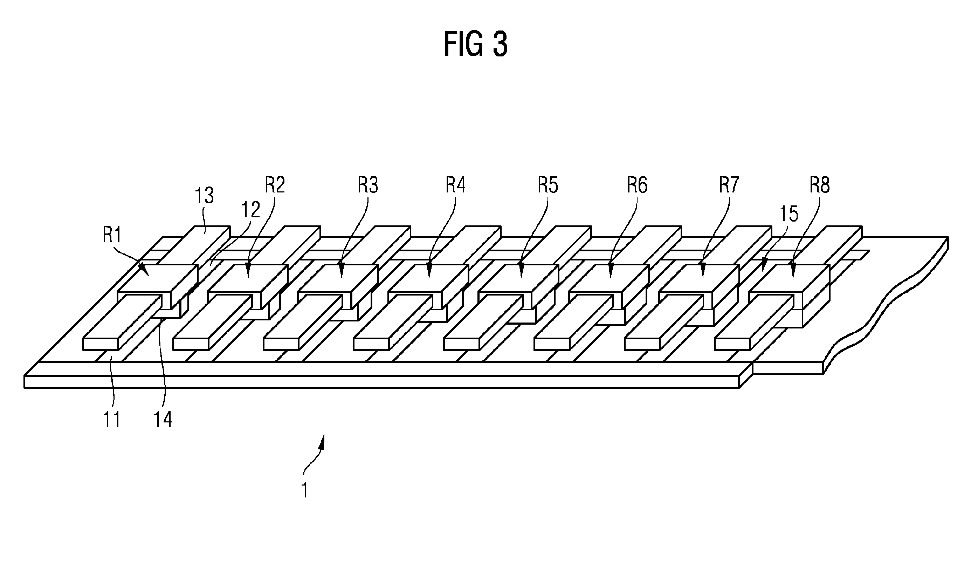

Mit der FIG 3 ist als ein Ausschnitt aus dem Halbleiterspeicherbaustein 1 eine Kaskade von Referenzspeicherzellen R1,...,R8 dargestellt. Jede Referenzspeicherzelle R1,...,R8 weist einen Source-Anschluss 11, einen Drain-Anschluss 12, einen Control-Gate-Anschluss 13 und ein Floating-Gate 14 auf. In aufsteigender Reihenfolge von der ersten Referenzspeicherzelle R1 bis zur achten Referenzspeicherzelle R8 nimmt die bauliche Größe des Floating-Gates 14 einer jeden Referenzspeicherzelle R1,...,R8 zunehmend zu.

In Weiterführung zu dem in FIG 1 dargestellten Auslesemittel 20 würde das Auslesemittel 20 nun mit Datenverbindungen zu je einer Referenzspeicherzelle R1,...,R8 ausgestaltet sein. Durch die Abfrage der einzelnen Referenzspeicherzellen R1,...,R8 kann eine Aussage, über einen bereits erfolgten Abfluss von elektrischer Ladung in Prozentangabe aus den Speicherzellen 101,...,108 erfolgen. Ein derartig kaskadiertes Register von Referenzspeicherzellen R1,...,R8 könnte auch in herstellereigenentwickelten ASICS eingebaut werden. Durch die Kaskadierung der Referenzspeicherzellen R1,...,R8 in einem Register kann eine abgestufte Aussage über eine mögliche Ausfallzeit der Speicherzellen 101,...,108 realisiert werden. Eine Information in der ersten Referenzspeicherzelle R1 würde nach der beschriebenen Bauart schneller verloren gehen, als eine Information in der zweiten Referenzspeicherzelle R2.

Insbesondere bei einer Anwendung von Halbleiterspeicherbausteinen 1 in der Automatisierungstechnik, insbesondere in der Industrieprozessautomatisierungstechnik, könnte bezogen auf eine Ausfallzeit von ca. 20 Jahren eine Referenzspeicherzelle beispielsweise auf 10 bis 20 Prozent ausgelegt werden. Insbesondere bei Automatisierungskomponenten, welche als fehlersichere Baugruppen für besonders kritische Prozesse ausgelegt sind, ist es wichtig, einen Auffrischzeitpunkt zum Auffrischen der Daten in dem Halbleiterspeicherbaustein 1 vor einem Defekt bestimmen zu können. Dabei werden durch die Bauart, nämlich das die Referenzspeicherzellen R1,...,R8 auf der gleichen baulichen Einheit des Halbleiterspeicherbausteins 1 wie die Speicherzellen 101,...,108 angeordnet sind, alle Einflüsse, welche auf den Halbleiterspeicherbaustein 1 wirken, insbesondere die Umgebungstemperatur, berücksichtigt.

## Patentansprüche

1. Halbleiterspeicherbaustein (1) mit einer Vielzahl von Speicherzellen (101,...,108), wobei je eine Speicherzelle (101,..., 108) zum Abspeichern einer Information (10) ausgestaltet ist und die Information (10) in Form einer elektrischen Ladung vorliegt,
**gekennzeichnet, durch**
eine Referenzspeicherzelle (R1,...,R8), welche gegenüber den anderen Speicherzellen (101,...,108) derart verändert ausgestaltet ist, dass ihre Retention gegenüber der Retention der anderen Speicherzellen (101,...,108) geringer ist.

2. Halbleiterspeicherbaustein (1) nach Anspruch 1, wobei die Speicherzellen (101,...,108) und die Referenzspeicherzelle (R1,...,R8) jeweils als ein Floating-Gate-Transistor aufgebaut sind.

3. Halbleiterspeicherbaustein (1) nach Anspruch 2, wobei die die Speicherzelle (101,...,108) einen Source-Anschluss (11), einen Drain-Anschluss (12) und einen Control-Gate-Anschluss (13) aufweist, wobei ein Floating-Gate (14) zwischen dem Source-Anschluss (11) und dem Drain-Anschluss (12) unterhalb des Control-Gate-Anschlusses (13) innerhalb einer Oxidschicht (15) angeordnet ist.

4. Halbleiterspeicherbaustein (1) nach einem der Ansprüche 1 bis 3, wobei die Referenzspeicherzelle (R1,...,R8) ausgestaltet ist ausgehend von einem ersten Zeitpunkt des Beschreibens mit Informationen der Referenzspeicherzelle (R1,...,R8) und der anderen Speicherzellen (101,...,108) schneller ihre elektrische Ladung bis zu einem zweiten Zeitpunkt zu verlieren, als die Speicherzellen (101,...,108) ihre elektrische Ladung bis zu diesem zweiten Zeitpunkt verlieren.

5. Halbleiterspeicherbaustein (1) nach Anspruch 3 oder 4, wobei eine Größe des Floating-Gates (14) der Referenzspeicherzelle (R1,...,R8) kleiner ist als eine Größe eines Floating-Gates (14) einer Speicherzelle (101,...,108).

6. Halbleiterspeicherbaustein (1) nach einem der Ansprüche 1 bis 5, wobei die Referenzspeicherzelle (R1,...,R8) derart zwischen oder in der Nähe der anderen Speicherzellen (101,...,108) angeordnet ist, dass auf die Referenzspeicherzelle (R1,...,R8) im Wesentlichen die gleichen Einflüsse wirken, wie auf die anderen Speicherzellen (101,...,108).

7. Halbleiterspeicherbaustein (1) nach Anspruch 6, wobei die Einflüsse Folgendes umfassen, eine Umgebungstemperatur, eine herstellerspezifische Fertigungstechnologie, eine Größe der Versorgungsspannung, eine Anzahl von Schreibvorgängen.

8. Halbleiterspeicherbaustein (1) nach einem der Ansprüche 1 bis 7, **gekennzeichnet durch** weitere Referenzspeicherzellen (R1,...,R8), wobei diese weiteren Referenzspeicherzellen (R1,...,R8) kaskadiert sind und dabei in dieser Kaskade die Größe des Floating-Gates (14) von einer Referenzspeicherzelle (R1) zur nächsten Referenzspeicherzelle (R2) zunimmt.

9. Verfahren zum Berieb eines Halbleiterspeicherbausteins (1) mit einer Vielzahl von Speicherzellen (101,...,108), wobei je eine Speicherzelle (101,...,108) zum Abspeichern einer Information (10) genutzt wird und die Information (10) in Form einer elektrischen Ladung abgespeichert wird,
**gekennzeichnet durch** eine zyklische Abfrage einer Referenzspeicherzelle (R1,...,R8), wobei die Referenzspeicherzelle (R1, ..., R8) gegenüber den anderen Speicherzellen (101, ..., 108) derart verändert ausgestaltet ist, das ihre Retention gegenüber der Retention der anderen Speicherzellen (101,...,108) geringer ist, wobei die Referenzspeicherzelle (R1,...,R8) ausgehend von einem ersten Zeitpunkt des Beschreibens mit einer Information (10) der Referenzspeicherzelle (R1, ..., R8) und der anderen Speicherzellen (101,...,108) schneller ihre elektrische Ladung bis zu einem zweiten Zeitpunkt verliert, als die Speicherzellen (101,...,108) ihre elektrische Ladung bis zu diesem zweiten Zeitpunkt verlieren, ergibt die zyklische Abfrage der Referenzspeicherzelle (R1,...,R8), dass die zuvor eingeschriebene Information (10) nicht mehr zurücklesbar ist, so wird ein Auffrischungsvorgang der anderen Speicherzellen (101,..., 108) gestartet.

10. Verfahren nach Anspruch 9, wobei weitere Referenzspeicherzellen (R1,...,R8) abgefragt werden, wobei diese weiteren Referenzspeicherzellen (R1,...,R8) kaskadiert sind und dabei in dieser Kaskade die Größe des Floating-Gates (14) von einer Referenzspeicherzelle (R1) zur nächsten Referenzspeicherzelle (R2) zunimmt, wodurch eine Aussage über einen bereits erfolgten Abfluss von elektrischer Ladung aus den Speicherzellen (101,..., 108) getroffen wird.
